# EUROPÄISCHE PATENTSCHRIFT

(11) **EP 1 224 480 B1**
(45) Veröffentlichungstag und Bekanntmachung des Hinweises auf die Patenterteilung: **29.10.2003**
(21) Anmeldenummer: 00963939.4
(22) Anmeldetag: 28.08.2000
(51) Int. Cl.: G01R 31/3185

(54) **PROGRAMMGESTEUERTE EINHEIT UND VERFAHREN ZUM ERKENNEN UND/ODER ANALYSIEREN VON FEHLERN IN PROGRAMMGESTEUERTEN EINHEITEN**
PROGRAMME-CONTROLLED UNIT AND METHOD FOR IDENTIFYING AND/OR ANALYSING ERRORS IN PROGRAMME-CONTROLLED UNITS
UNITE A COMMANDE PAR PROGRAMME ENREGISTRE ET PROCEDE PERMETTANT DE DETECTER ET/OU D'ANALYSER DES ERREURS DANS CES UNITES A COMMANDE PAR PROGRAMME ENREGISTRE

(30) Priorität: 30.08.1999 DE 19941099
(43) Veröffentlichungstag der Anmeldung: 24.07.2002
(73) Patentinhaber: Infineon Technologies AG, 81669 München (DE)
(72) Erfinder: MAYER, Albrecht, D-82041 Deisenhofen (DE); PFAB, Stefan, D-82049 Pullach (DE); KAIBEL, Martin, D-81371 München (DE)
(74) Vertreter: Repkow, Ines, Dr. Dipl.-Ing.
(86) Internationale Anmeldenummer: DE0002956
(87) Internationale Veröffentlichungsnummer: WO01016609

(56) Entgegenhaltungen:
- EP-A- 0 926 598
- US-A- 5 920 575

## Beschreibung

Die vorliegende Erfindung betrifft eine Vorrichtung gemäß dem Oberbegriff des Patentanspruchs 1 und ein Verfahren gemäß dem Oberbegriff des Patentanspruchs 7, d.h. eine programmgesteuerte Einheit mit zu einer oder mehreren Scan-Ketten verschaltbaren Elementen und ein Verfahren zum Erkennen und/oder Analysieren von Fehlern in programmgesteuerten Einheiten unter Verwendung von Scan-Ketten.

EP-A- 0 926 598 beschreibt ein FPGA (field programmable gate array), welches aus einer Vielzahl von logik elementen besteht, die vom Benutzer wunschgemäß verschaltet und Konfiguriert werden.

Programmgesteuerte Einheiten wie insbesondere Mikroprozessoren, Mikrocontroller, Signalprozessoren und dergleichen sowie Verfahren zum Testen derselben sind seit langem in einer Vielzahl von Ausführungsformen bekannt.

Programmgesteuerte Einheiten mit Scan-Ketten und Verfahren zum Testen von programmgesteuerten Einheiten unter Verwendung von Scan-Ketten ermöglichen es, programmgesteuerte Einheiten besonders schnell und zuverlässig nach Fehlern zu untersuchen.

Die Scan-Ketten-Elemente sind üblicherweise ausgewählte oder alle Flip-Flops der zu testenden Schaltung. Diese Flip-Flops lassen sich beim Testen der zu testenden Schaltung zu einer oder mehreren Scan-Ketten verschalten. Die Flip-Flops werden dabei in Reihe hintereinandergeschaltet, wobei der Eingangsanschluß eines jeweiligen Flip-Flops mit dem Ausgangsanschluß des in der Reihe vor ihm stehenden Flip-Flops verbunden ist, und wobei der Ausgangsanschluß eines jeweiligen Flip-Flops mit dem Eingangsanschluß des in der Reihe nach ihm kommenden Flip-Flops verbunden ist.

Eine solche Scan-Kette, genauer gesagt deren im betrachteten Beispiel durch Flip-Flops gebildeten Elemente können relativ einfach initialisiert werden. Ein an den Eingangsanschluß des ersten Flip-Flops der Scan-Kette angelegtes Signal, genauer gesagt der sich im Ansprechen darauf einstellende Zustand des betreffenden Flip-Flops wird nämlich mit dem Takt eines an die Flip-Flops angelegten Taktsignals von Flip-Flop zu Flip-Flop weitergeschoben; jedes Flip-Flop der Scan-Kette nimmt mit jedem Taktimpuls den Zustand des in der Scan-Kette vor ihm stehenden Flip-Flops an.

Soll das x-te Flip-Flop der Scan-Kette in den Zustand A versetzt werden, so muß "nur" an den Eingangsanschluß des ersten Flip-Flops der Scan-Kette ein Signal angelegt werden, durch welches dieses Flip-Flop und die nachgeschalteten Flip-Flops in den Zustand A versetzbar sind, und die Scan-Kette (alle Flip-Flops derselben) mit x Taktimpulsen beaufschlagt werden.

Umgekehrt können am letzten Flip-Flop der Scan-Kette die Zustände der einzelnen Flip-Flops zu einem bestimmten Zeitpunkt sequentiell ausgelesen werden.

Enthält die Scan-Kette n Flip-Flops, so läuft der Test einer zu testenden Schaltung nach dem Scan-Verfahren wie folgt ab: Zunächst wird die Schaltung in die Scan-Betriebsart versetzt, wodurch sich die erwähnte Scan-Kette bildet. Diese Scan-Kette wird durch sequentielles Anlegen von n Eingangssignalen und n Taktimpulsen in einen definierten Anfangszustand versetzt. Danach wird die Scan-Kette aufgelöst, und die zu testende Schaltung kurzzeitig testweise in Betrieb genommen. Dabei verändern sich zumindest teilweise die Zustände der anfänglich initialisierten Flip-Flops, wobei sich aus der bestimmungsgemäßen Funktion der zu testenden Schaltung ermitteln läßt, in welchem (Soll-)Zustand die Flip-Flops sich zu einem jeweiligen Zeitpunkt befinden müßten. Verschaltet man die Flip-Flops nach einer gewissen Zeit wieder zur Scan-Kette und beaufschlagt sie mit Taktsignalen, so werden am Ende der Scan-Kette (aus dem Ausgangsanschluß des letzten Flip-Flops der Scan-Kette) sequentiell im Takt der Taktsignale Daten herausgeschoben, welche den (Ist-)Zustand der Flip-Flops der Scan-Kette zum Zeitpunkt des Endes des Test-Betriebs der Schaltung repräsentieren. Vergleicht man sodann den wie beschrieben ermittelten Ist-Zustand der Flip-Flops der Scan-Kette mit dem bekannten Soll-Zustand derselben, so läßt sich daran ersehen, ob die zu testende Schaltung fehlerfrei läuft oder nicht.

Bei geeigneter Vorgehensweise lassen sich auf die beschriebene Art und Weise fast alle Fehler in programmgesteuerten Einheiten schnell und einfach erkennen.

Die Erfahrung zeigt jedoch, daß bestimmte Fehler bei einem wie vorstehend beschrieben durchgeführten Schaltungstest nicht erkannt werden. Dies betrifft insbesondere Fehler, die nur unter ganz bestimmten Bedingungen auftreten. Solche Fehler sind beispielsweise Fehler, die nur zu einem bestimmten Zeitpunkt nach der Inbetriebnahme der Schaltung in einer ganz bestimmten Umgebung auftreten (beispielsweise Fehler, die nur ungefähr 30 Sekunden nach der Inbetriebnahme der Schaltung bei einer Umgebungstemperatur von -20°C und einer Versorgungsspannung von 5,3 V auftreten).

Solche Fehler lassen sich derzeit nicht, jedenfalls nicht zuverlässig, erkennen und analysieren. Dies ist häufig selbst dann der Fall, wenn die Umstände, unter welchen die Fehler auftreten, bekannt sind.

Der vorliegenden Erfindung liegt daher die Aufgabe zugrunde, die Vorrichtung gemäß dem Oberbegriff des Patentanspruchs 1 und das Verfahren gemäß dem Oberbegriff des Patentanspruchs 7 derart weiterzubilden, daß sich auch solche Fehler schnell und zuverlässig erkennen und/oder analysieren lassen, die nur unter bestimmten Umständen auftreten.

Diese Aufgabe wird erfindungsgemäß durch die im kennzeichnenden Teil des Patentanspruchs 1 beanspruchten Merkmale (Vorrichtung) bzw. durch die im kennzeichnenden Teil des Patentanspruchs 7 beanspruchten Merkmale (Verfahren) gelöst.

Demnach ist vorgesehen,
- daß sich die programmgesteuerte Einheit während der Programmausführung im Ansprechen auf ein vorbestimmtes Ereignis in einen Zustand versetzen kann, in welchem ausgewählte oder alle der zu Scan-Ketten verschaltbaren Elemente ihren Zustand nicht mehr ändern können (kennzeichnender Teil des Patentanspruchs 1) bzw.
- daß die Scan-Ketten ausgelesen werden, nachdem während der Ausführung eines Programms durch die programmgesteuerte Einheit ein vorbestimmtes Ereignis aufgetreten ist (kennzeichnender Teil des Patentanspruchs 7).

Versetzt sich die programmgesteuerte Einheit während der Programmausführung im Ansprechen auf ein vorbestimmtes Ereignis in einen Zustand, in welchem ausgewählte oder alle der zu Scan-Ketten verschaltbaren Elemente ihren Zustand nicht mehr ändern können, und verschaltet man anschließend die zu einer Scan-Kette verschaltbaren Elemente zu einer Scan-Kette und liest diese aus, so kann man aus den dabei erhaltenen Daten schnell und zuverlässig auch solche Fehler in der programmgesteuerten Einheit erkennen, die nur unter bestimmten Umständen auftreten.

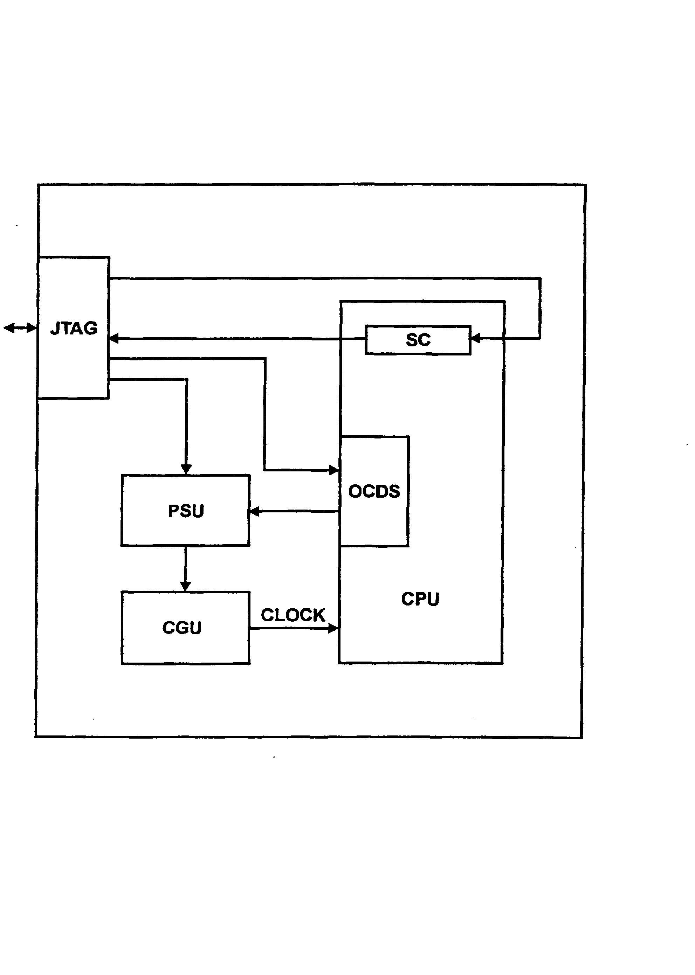

Vorteilhafte Weiterbildungen der Erfindung sind den Unteransprüchen, der nachfolgenden Beschreibung und der Figur entnehmbar.

Die Erfindung wird nachfolgend anhand von Ausführungsbeispielen unter Bezugnahme auf die Figur näher erläutert.

Die Figur zeigt schematisch den Aufbau der nachfolgend näher beschriebenen programmgesteuerten Einheit.

Bei der nachfolgend beschriebenen programmgesteuerten Einheit handelt es sich um einen Mikroprozessor, einen Mikrocontroller, einen Signalprozessor oder dergleichen.

Der prinzipielle Aufbau der betrachteten programmgesteuerten Einheit ist in der Figur dargestellt. Der Vollständigkeit halber sei darauf hingewiesen, daß in der Figur nur die vorliegend besonders interessierenden Bestandteile der programmgesteuerten Einheit gezeigt sind.

Der vollständige Aufbau von programmgesteuerten Einheiten, deren Funktion und deren Wirkungsweise sind allgemein bekannt und bedürfen keiner näheren Erläuterung.

Die betrachtete programmgesteuerte Einheit läßt sich unter Verwendung einer oder mehrerer Scan-Ketten testen. Sie zeichnet sich dadurch aus, daß sie sich während der Programmausführung im Ansprechen auf ein vorbestimmtes Ereignis in einen Zustand versetzen kann, in welchem ausgewählte oder alle der zu Scan-Ketten verschaltbaren Elemente ihren Zustand nicht mehr ändern können. Verschaltet man anschließend die zu Scan-Ketten verschaltbaren Elemente zu einer oder mehreren Scan-Ketten und liest diese aus, so erhält man damit die Zustände der Scan-Ketten-Elemente zum Zeitpunkt des vorbestimmten Ereignisses. Repräsentiert das vorbestimmte Ereignis eine Fehlfunktion der programmgesteuerten Einheit oder ein kurz davor oder danach liegendes Ereignis, so kann aus den aus den Scan-Ketten ausgelesenen Daten die Ursache der Fehlfunktion ermittelt und/oder analysiert werden.

Um die Abweichungen der aus den Scan-Ketten ausgelesenen Daten gegenüber den Daten, die man im ungestörten Normalfall erhalten würde, erkennen zu können, vergleicht man diese vorzugsweise mit den entsprechenden Daten einer die betreffende Fehlfunktion nicht aufweisenden programmgesteuerten Einheit.

Die in der Figur dargestellten Bestandteile der programmgesteuerten Einheit umfassen eine CPU, einen Taktgenerator CGU, eine On-Chip-Debug-Support-Einheit OCDS, ein JTAG-Modul JTAG, und eine Prozessor-Anhalte-Einheit PSU; ausgewählte oder alle Flip-Flops der programmgesteuerten Einheit können zu einer oder mehreren Scan-Ketten SC verschaltet werden.

Im normalen Betrieb der programmgesteuerten Einheit arbeitet diese, genauer gesagt die CPU derselben, auszuführende Programme ab; die die dabei auszuführenden Befehle repräsentierenden Daten sind in einem innerhalb oder außerhalb der programmgesteuerten Einheit vorgesehenen (in der Figur nicht gezeigten) Programmspeicher gespeichert.

Die CPU und die anderen Komponenten der programmgesteuerten Einheit arbeiten im Takt der vom Taktgenerator TGU erzeugten Taktsignale CLOCK.

Die Scan-Ketten SC und die On-Chip-Debug-Support-Einheit dienen zur Erkennung und/oder Analyse von Hardware- und/oder Softwarefehlern.

Der Aufbau und der Betrieb von Scan-Ketten wurden bereits ausführlich beschrieben und bedürfen keiner weiteren Erläuterung.

Der On-Chip-Debug-Support-Einheit obliegt es, das Auftreten bestimmter Ereignisse zu überwachen und bei Auftreten des betreffenden Ereignisses in vorbestimmter Weise zu reagieren.

Die vorbestimmten Ereignisse bestehen beispielsweise darin, daß die programmgesteuerte Einheit auf eine bestimmte Speicheradresse im Programm- und/oder Datenspeicher zugreift, und/oder daß die programmgesteuerte Einheit vorbestimmte Daten aus dem Programm- und/oder Datenspeicher einliest oder an diesen ausgibt, und/oder daß ein vorbestimmtes Register der programmgesteuerten Einheit einen vorbestimmten Inhalt annimmt, und/oder daß sich sonstige Zustände einstellen, die als Break-Bedingungen in Debuggern verwendet werden können. Das vorbestimmte Ereignis kann auch darin bestehen, daß bestimmte Ereignisse gleichzeitig oder in einer bestimmten Aufeinanderfolge auftreten oder daß eine bestimmte Anzahl von Takten nach dem Auftreten eines bestimmten Ereignisses oder einer bestimmten Ereignisfolge verstrichen ist.

Bekannte On-Chip-Debug-Support-Einheiten reagieren auf das Auftreten des vorbestimmten Ereignisses dadurch, daß
- das Auftreten des Ereignisses an einem Ein- und/oder Ausgabeanschluß der programmgesteuerten Einheit signalisiert wird, und/oder
- daß ein sogenanntes Monitor-Programm gestartet wird, mit Hilfe dessen der Zustand und das Verhalten der programmgesteuerten Einheit genau kontrollierbar sind, und/oder
- daß die programmgesteuerte Einheit veranlaßt wird, die Programmausführung des eigentlich auszuführenden Programms beispielsweise durch wiederholte Ausführung von NOP-Befehlen zu unterbrechen oder zu stoppen.

Bei der vorliegend näher betrachteten programmgesteuerten Einheit ist die OCDS-Einheit zusätzlich oder alternativ in der Lage, die programmgesteuerte Einheit in einen Zustand zu versetzen, in welchem ausgewählte oder alle der zu Scan-Ketten verschaltbaren Elemente ihren Zustand nicht mehr ändern können.

Dies wird im betrachteten Beispiel dadurch erreicht, daß der Taktgenerator CGU deaktiviert wird. Durch den Wegfall der vom Taktgenerator CGU erzeugten Taktsignale wird der augenblickliche Zustand derjenigen Bestandteile der programmgesteuerten Einheit, die vom Taktgenerator CGU mit Taktsignalen versorgt werden, eingefroren.

Der Vollständigkeit halber sei darauf hingewiesen daß das Einfrieren der augenblicklichen Zustände der zu Scan-Ketten verschaltbaren Elemente auch auf mannigfaltige andere Art und Weise bewerkstelligt werden kann.

Im betrachteten Beispiel versorgt der Taktgenerator CGU die gesamte programmgesteuerte Einheit mit Taktsignalen; daher wird vorliegend der Zustand der gesamten programmgesteuerten Einheit eingefroren. Es sei jedoch darauf hingewiesen, daß es nicht zwingend erforderlich ist, die gesamte programmgesteuerte Einheit anzuhalten.

Die Deaktivierung des Taktgenerators CGU erfolgt über die Prozessor-Anhalte-Einheit PSU; diese deaktiviert den Taktgenerator CGU auf Veranlassung der On-Chip-Debug-Support-Einheit OCDS.

Nachdem der Taktgenerator CGU deaktiviert ist, können diejenigen Bestandteile der programmgesteuerten Einheit, die üblicherweise vom Taktgenerator CGU mit Taktsignalen versorgt werden, ihren Zustand nicht mehr ändern.

Es ist aber nach wie vor möglich, die zu Scan-Ketten verschaltbaren Elemente zu einer oder mehreren Scan-Ketten zusammenzuschalten und auszulesen.

Tut man dies, so erhält man umfassende Informationen über den Zustand der programmgesteuerten Einheit zum Zeitpunkt des Auftretens des von der OCDS-Einheit erfaßten vorbestimmten Ereignisses.

Die aus den Scan-Ketten ausgelesenen Daten werden vorzugsweise mit entsprechenden Daten einer fehlerfrei arbeitenden programmgesteuerten Einheit verglichen. Anhand der dabei feststellbaren Unterschiede kann der in der fehlerhaft arbeitenden programmgesteuerten Einheit vorhandene Fehler schnell und einfach erkannt, lokalisiert und/oder analysiert werden.

Die On-Chip-Debug-Support-Einheit OCDS, die Prozessor-Anhalte-Einheit PSU und die Scan-Ketten SC können über das JTAG-Modul extern (von außerhalb der programmgesteuerten Einheit) gesteuert werden.

Das JTAG-Modul ist ein bekanntes Interface und bedarf keiner näheren Erläuterung.

Der OCDS-Einheit ist über das JTAG-Interface unter anderem mitteilbar
- ob sie das Auftreten vorbestimmter Ereignisse überwachen soll,
- worin das vorbestimmte Ereignis besteht, und/oder
- wie die OCDS-Einheit auf das Auftreten des vorbestimmten Ereignisses reagieren soll.

Der Prozessor-Anhalte-Einheit ist über das JTAG-Interface mitteilbar, ob und gegebenenfalls wie sie auf Anforderungen seitens der OCDS-Einheit reagieren soll.

Die Scan-Ketten SC sind über das JTAG-Interface zusammensetzbar, auflösbar, auslesbar und beschreibbar.

Damit sind sämtliche Operationen, die zu einer wie vorstehend beschrieben erfolgenden Erkennung und/oder Analyse von Fehlern in der programmgesteuerten Einheit in dieser durchgeführt werden müssen, über eine Standardschnittstelle von außerhalb der programmgesteuerten Einheit veranlaßbar. Bei entsprechendem Ausbau des die programmgesteuerte Einheit enthaltenden Systems kann so eine Fehlererkennung und eine Fehleranalyse durchgeführt werden, ohne die programmgesteuerte Einheit aus dem sie enthaltenden System entfernen zu müssen. Dies erweist sich als großer Vorteil, weil die Fehlererkennung und Fehleranalyse dadurch maximal einfach und zuverlässig wird.

Durch die beschriebene programmgesteuerte Einheit und das beschriebene Verfahren lassen sich in programmgesteuerten Einheiten vorhandene Fehler auch dann, wenn sie nur unter bestimmten Umständen auftreten, schnell und zuverlässig erkennen und analysieren.

### Bezugszeichenliste

- CLOCK: Taktsignal
- CPU: CPU
- CGU: Taktgenerator
- OCDS: On-Chip-Debug-Support-Einheit
- JTAG: JTAG-Modul
- PSU: Prozessor-Anhalte-Einheit
- SC: Scan-Kette

## Patentansprüche

1. Programmgesteuerte Einheit mit zu einer oder mehreren Scan-Ketten (SC) verschaltbaren Elementen,
**dadurch gekennzeichnet,**
**daß** sich die programmgesteuerte Einheit während der Programmausführung im Ansprechen auf ein vorbestimmtes Ereignis in einen Zustand versetzen kann, in welchem ausgewählte oder alle der zu Scan-Ketten verschaltbaren Elemente ihren Zustand nicht mehr ändern können.

2. Programmgesteuerte Einheit nach Anspruch 1,
**dadurch gekennzeichnet,**
**daß** die Überwachung des Auftretens des vorbestimmten Ereignisses durch eine in der programmgesteuerten Einheit vorgesehene On-Chip-Debug-Support-Einheit (OCDS) erfolgt.

3. Programmgesteuerte Einheit nach Anspruch 1 oder 2,
**dadurch gekennzeichnet,**
**daß** das Versetzen der programmgesteuerten Einheit in einen Zustand, in welchem ausgewählte oder alle der zu Scan-Ketten (SC) verschaltbaren Elemente ihren Zustand nicht mehr ändern können, durch ein Deaktivieren eines die betreffenden Teile der programmgesteuerten Einheit mit Taktsignalen (CLOCK) versorgenden Taktgenerators (CGU) erfolgt.

4. Programmgesteuerte Einheit nach einem der vorhergehenden Ansprüche,
**dadurch gekennzeichnet,**
**daß** die programmgesteuerte Einheit eine Schnittstelle (JTAG) aufweist, über welche zum Erkennen und/oder Analysieren von in der programmgesteuerten Einheit vorhandenen Fehlern vorgesehene Teile der programmgesteuerten Einheit von außerhalb der programmgesteuerten Einheit konfigurierbar und/oder steuerbar sind.

5. Programmgesteuerte Einheit nach Anspruch 4,
**dadurch gekennzeichnet,**
**daß** über die Schnittstelle (JTAG) das vorbestimmte Ereignis und die Reaktion der programmgesteuerten Einheit auf das Auftreten des vorbestimmten Ereignisses einstellbar sind.

6. Programmgesteuerte Einheit nach Anspruch 4 oder 5,
**dadurch gekennzeichnet,**
**daß** über die Schnittstelle (JTAG) das Verschalten der zu einer Scan-Kette (SC) verschaltbaren Elemente zu einer Scan-Kette sowie das Auslesen und Beschreiben der Scan-Kette veranlaßbar bzw. durchführbar sind.

7. Verfahren zum Erkennen und/oder Analysieren von Fehlern in programmgesteuerten Einheiten unter Verwendung von Scan-Ketten (SC),
**dadurch gekennzeichnet,**
**daß** die Scan-Ketten im Ansprechen auf das Auftreten eines während der Ausführung eines Programms durch die programmgesteuerte Einheit auftretenden vorbestimmten Ereignisses durch die programmgesteuerte Einheit in einen Zustand versetzt werden, in welchem ausgewählte oder alle der zu Scan-Ketten (SC) verschaltbaren Elemente ihren Zustand nicht mehr ändern können.

8. Verfahren nach Anspruch 7,
**dadurch gekennze1chnet,**
daß die Scan-Ketten nach dem Auftreten des vorbestimmtes Ereignisses ausgelesen werden.

9. Verfahren nach Anspruch 7 oder 8,
**dadurch gekennzeichnet,**
**daß** die beim Auslesen der Scan-Ketten (SC) erhaltenen Daten mit Daten verglichen werden, die bei einem unter den selben Bedingungen erfolgenden Auslesen der Scan-Ketten einer fehlerfreien programmgesteuerten Einheit erhalten werden.

## Claims

1. Program-controlled unit having elements which can be connected to form one or more scan chains (SC),
**characterized**
**in that**, in response to a predetermined event during program execution, the program-controlled unit can change to a state in which selected ones or all of the elements which can be connected to form scan chains are no longer able to change their state.

2. Program-controlled unit according to Claim 1,
**characterized**
**in that** the occurrence of the predetermined event is monitored by an On-Chip Debug Support unit (OCDS) provided in the program-controlled unit.

3. Program-controlled unit according to Claim 1 or 2,
**characterized**
**in that** the program-controlled unit is changed to a state in which selected ones or all of the elements which can be connected to form scan chains (SC) can no longer change their state by deactivating a clock generator (CGU) which supplies the relevant parts of the program-controlled unit with clock signals (CLOCK) .

4. Program-controlled unit according to one of the preceding claims,
**characterized**
**in that** the program-controlled unit has an interface (JTAG) which can be used to configure and/or control parts of the program-controlled unit which are provided for identifying and/or analysing errors which have occurred in the program-controlled unit from outside the program-controlled unit.

5. Program-controlled unit according to Claim 4,
**characterized**
**in that** the interface (JTAG) can be used to set the predetermined event and the reaction of the
program-controlled unit to the occurrence of the predetermined event.

6. Program-controlled unit according to Claim 4 or 5,
**characterized**
**in that** the interface (JTAG) can be used to prompt or effect connection of the elements which can be connected to form a scan chain (SC) so that they form a scan chain, and also reading of and writing to the scan chain.

7. Method for identifying and/or analysing errors in program-controlled units using scan chains (SC),
**characterized**
**in that** in response to the occurrence of a predetermined event occurring during execution of a program by the program-controlled unit, the program-controlled unit puts the scan chains into a state in which selected instances or all of the elements which can be connected up to form scan chains (SC) cannot change their state any longer.

8. Method according to Claim 7,
**characterized**
**in that** the scan chains are read after the occurrence of the predetermined event.

9. Method according to Claim 7 or 8,
**characterized**
**in that** the data obtained when the scan chains (SC) are read are compared with data which are obtained when the scan chains in an error-free program-controlled unit are read under the same conditions.

## Revendications

1. Unité programmable comprenant un ou plusieurs éléments pouvant être interconnectés en chaînes de scrutation (SC), **caractérisée en ce que** l'unité programmable, pendant l'exécution du programme et en réaction à un événement donné, peut basculer dans un état dans lequel une sélection ou la totalité des éléments pouvant être interconnectés en chaînes de scrutation ne peuvent plus changer d'état.

2. Unité programmable selon la revendication 1, **caractérisée en ce que** la surveillance de l'apparition de l'événement donné est effectuée par une unité monochip d'assistance au débogage (OCDS) prévue dans l'unité programmable.

3. Unité programmable selon la revendication 1 ou 2, **caractérisée en ce que** le basculement de l'unité programmable dans un état dans lequel une sélection ou la totalité des éléments pouvant être interconnectés en chaînes de scrutation (SC) ne peut plus changer d'état s'effectue en désactivant un générateur d'horloge (CGU) qui délivre des signaux d'horloge (CLOCK) aux parties concernées de l'unité programmable.

4. Unité programmable selon l'une des revendications précédentes, **caractérisée en ce que** l'unité programmable présente une interface (JTAG) par le biais de laquelle des parties prévues de l'unité programmable peuvent être configurées et/ou commandées depuis l'extérieur de l'unité programmable pour détecter et/ou analyser les défauts présents dans l'unité programmable.

5. Unité programmable selon la revendication 4, **caractérisée en ce que** l'événement donné et la réaction de l'unité programmable à l'apparition de l'événement donné peuvent être définis par le biais de l'interface (JTAG).

6. Unité programmable selon la revendication 4 ou 5, **caractérisée en ce que** l'interconnexion en une chaîne de scrutation des éléments pouvant être interconnectés en une chaîne de scrutation (SC) ainsi que la lecture et l'écriture de la chaîne de scrutation peuvent être initiées ou exécutées par le biais de l'interface (JTAG).

7. Procédé pour détecter et/ou analyser des défauts dans les unités programmables en utilisant des chaînes de scrutation (SC), **caractérisé en ce que** les chaînes de scrutation, en réaction à l'apparition d'un événement donné qui se produit pendant l'exécution d'un programme par l'unité programmable, sont mises par l'unité programmable dans un état dans lequel une sélection ou la totalité des éléments pouvant être interconnecté s en chaînes de scrutation (SC) ne peuvent plus changer d'état.

8. Procédé selon la revendication 7, **caractérisé en ce que** les chaînes de scrutation sont lues après l'apparition de l'événement donné.

9. Procédé selon la revendication 7 ou 8, **caractérisé en ce que** les données obtenues lors de la lecture des chaînes de scrutation (SC) sont comparées avec les données qui ont été obtenues lors de la lecture effectuée sous les mêmes conditions des chaînes de scrutation d'une unité programmable sans défaut.
